(19) Europäisches Patentamt

European Patent Office

Office européen des brevets

(11) Veröffentlichungsnummer: **0 483 937 A1**

# (12) EUROPÄISCHE PATENTANMELDUNG

(21) Anmeldenummer: **91250291.1**

(22) Anmeldetag: **24.10.91**

(51) Int. Cl.5: **C25D 5/00**, C25D 17/00

(30) Priorität: **24.10.90 DE 4034298**
**21.08.91 DE 4127866**

(43) Veröffentlichungstag der Anmeldung:
**06.05.92 Patentblatt 92/19**

(84) Benannte Vertragsstaaten:
**AT BE CH DE DK ES FR GB GR IT LI LU NL SE**

(71) Anmelder: **SCHERING AKTIENGESELLSCHAFT**
**Müllerstrasse 170/178**
**W-1000 Berlin 65(DE)**

(72) Erfinder: **Bläsing, Horst**
**Strünckweg 1**
**W-1000 Berlin 13(DE)**

(54) **Membranelektrolysemodul, Verfahren und dessen Verwendung.**

(57) Membranelektrolysemodul, wobei die Elektrolysezelle aus einem Katolyt- und einem Anolytraum, die als durchflutbare Kammern ausgebildet sind, Verfahren und dessen Verwendung.

Die Erfindung betrifft einen Membranelektrolysemodul, Verfahren und dessen Verwendung.

In der Praxis werden zur elektrolytischen Schichtabscheidung verschiedene Elektrolysezellen benutzt, beispielsweise beschrieben in den Schriften FR 26 17 509, FR 21 12 179, AT EP 00 48 579, US-PS 12 21 299, US-PS 41 32 609, US-PS 24 87 399, US-PS 41 53 531 und US-PS 47 78 572. Das Erhalten einer gleichmäßigen Schicht, bzw. Schichtdicke ist problematisch, da oft auf strukturierten und nicht planar ausgebildeten Flächen abgeschieden werden muß, (Galvanotechnik 71 (1980) 1).

Das Erreichen einer guten Schichtdickenverteilung erfordert stabile und über die Fläche einheitliche Abscheidungsbedingungen; besonders eine über die Fläche konstante Stromdichte.

Aus dem Stand der Technik ist bekannt, daß man zur Optimierung dieser Prozesse Ionenaustauschermembranen einsetzen kann.

Eine Auswahl der Art und Qualität der bisher bekannten Ionenaustauschermembranen beeinhaltet die Verwendung von modifizierten HULL-Zellen in Abhängigkeit von der verwendeten Schichtabscheidungstechnologie. Solche bekannten Ionenaustauschermembranen sind in ihrem Grundaufbau besonders aufwendig und lassen sich nicht ohne weiteres in automatischen Durchlaufanlagen einsetzen.

Aufgabe der Erfindung ist es, ein Membranelektrolysemodul zu entwickeln, das gleichmäßige Schichtdickenverteilung auf der zu behandelnden Leiterplatten bewirkt und welches sich auch bei der Auflösung metallischer Oberflächen einsetzen läßt.

Diese Aufgabe wird erfindungsgemäß durch den in den Patentanspruchen gekennzeichneten Gegenstand gelöst.

Die Elektrolysezelle besteht aus einem Katholyt und einem Anolytraum, die als durchflutbare Kammern ausgebildet sind, indem durch planparallel zum zu behandelnden Warengut nichtporöse Ionenaustauschermembranen angeordnet werden und die lediglich durch Anionenaustauschermembranen getrennt sind.
Aufgrund der besonderen kammerartigen Anordnung kann die Elektrolytführung gezielter erfolgen und wegen eines möglichen geringeren Kammervolumens muß weniger Elektrolyt umgepumpt werden.

Bei einer besonderen Ausführungsvariante wird der Elektrolyt in der Mitte des Katodenraumes eingeleitet und tritt am Ein- bzw. Auslauf des zu behandelnden Gutes, insbesondere der Leiterplatte, wieder aus der Kammer heraus. Die Elektrolytführung in den Anodenkammern kann von den Seiten quer zur Transportrichtung der Leiterplatten erfolgen, oder über Leitkanäle realisiert werden.

Vorschlagsmäßig besteht solch ein Modul aus einem Elektrolytvorlagebehälter und Katolyt- bzw. Anolytkammer, die in Verbindung mit einer Pumpe einen Kreislauf bilden, wobei der Elektrolyt vor Eintritt in den Galvanisierteil filtriert werden kann.

Bedingt durch die Realisierung kleinster Elektrolysekammern aufgrund der getrennten Elektrolyte, die mit löslichen oder unlöslichen Anoden versehen sein können, ist gegenüber den bisher bekannten Elektrolysebausteinen ein wesentlich geringerer Elektrolysenbausteinen ein wesentlich geringerer Elektrolytumlauf erforderlich.

Mit dem erfindungsgemäßen Einsatz von Ionenaustauschermembranen ist es möglich, geringere Schichtdickenabweichungen zu erhalten, höhere Toleranzen bei der Prozeßsteuerung der Galvanisierung zuzulassen und eine bessere Anpassung der Schicht an vorgegebene Strukturen zu erreichen.

Die Auswahl der Art und Qualität der Ionenaustauschermembran ist unter Verwendung von modifizierten HULL-Zellen (DIN 50957) in Abhängigkeit von der verwendeten Schichtabscheidungstechnologie gut möglich. Die direkte Anordnung der kathodennahen Ionenaustauschermembran vor dem Kathodenmaterial ist für eine Schichtabscheidung auf feinstrukturiertem Galvanisiergut und großen ebenen Flächen vorteilhaft. Mit entsprechenden Vorteilen kann auch der Elektrolytaustausch des Elektrolyten eingesetzt werden. Erfindungsgemäß wird nicht der ganze Elektrolyt sondern nur ein Teil ausgetauscht, was die Anforderungen an die Austauschvorrichtung verringert. Die Unterbringung von unterschiedlichen Elektrolyten und/oder unterschiedlichen Zusatzstoffen, beziehungsweise deren Konzentrationen in den verschiedenen Teilen des Elektrolytvolumens ist vorteilhaft für die Auswahl des Anodenmaterials. Die Auswahlmöglichkeit der Werkstoffe ist größer.

Die beschriebene Verfahrensweise eignet sich ebenfalls zur Legierungs- und Monometallabscheidungen, wie auch für Standbäder mit ruhenden Elektrolyten und für den Einsatz in Vertikal- und Horizontaldurchlaufanlagen.

Die Erfindung wird anhand von Ausführungsbeispielen nachfolgend näher beschrieben.
Dabei stellen die Figuren 1 bis 3 folgendes dar:

Figur 1    Prinzip der Membranelektrolyse
Figur 2    Membranelektrolysemodul Variante 1
Figur 3    Membranelektrolysemodul Variante 2

**Bezugszeichenliste:**

1    Leiterplatte
2    Katolyt
3    Membrane
4    Anode
5    Anolyt

6 Gehäuse
7 Transporteinrichtung
8 Gehäuse
9 Plattenführungsrolle
10 Galvanisierzelle
11 Pumpe
12 Filter
13 Anolytstrom
14 Katolytstrom

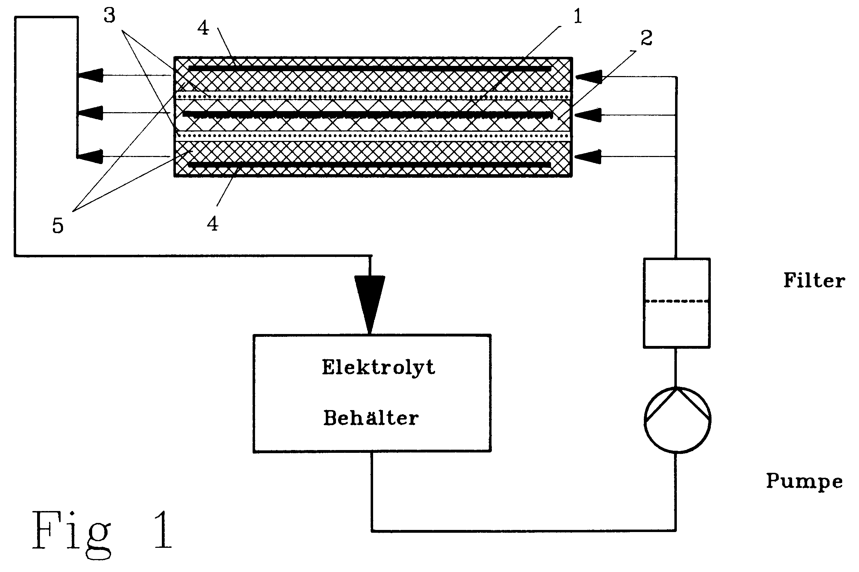

Gemäß der Figur 1 befindet sich die Leiterplatte 1 vorzugsweise in einem Membranelektrolysemodul, wobei die Leiterplatte 1 unterhalb und oberhalb mittels der Membranen 3 gehäusemäßig in zwei Kammern getrennt wird, so daß sich in der Mitte der Katolyt 2 befindet und oberhalb und unterhalb der Raum für den Anolyten 5 gebildet wird, wo dann die Anode 4 anliegt.

Diese Anordnung hat den Vorteil, daß nur der Katolyt 2 mit Abscheidungsmetallen versorgt werden muß, weil Anolyt 5 und Katolyt 2 in getrennten Kreisläufen zugeführt werden. Demzufolge können höhere Stromdichten und damit verbundener Gewährleistung von reineren galvanischen Niederschlägen Anwendung finden. Entsprechend unterschiedlicher Anwendungsvarianten können die Elektroden in ihrer Position verstellt werden.

**Beispiel 1:**

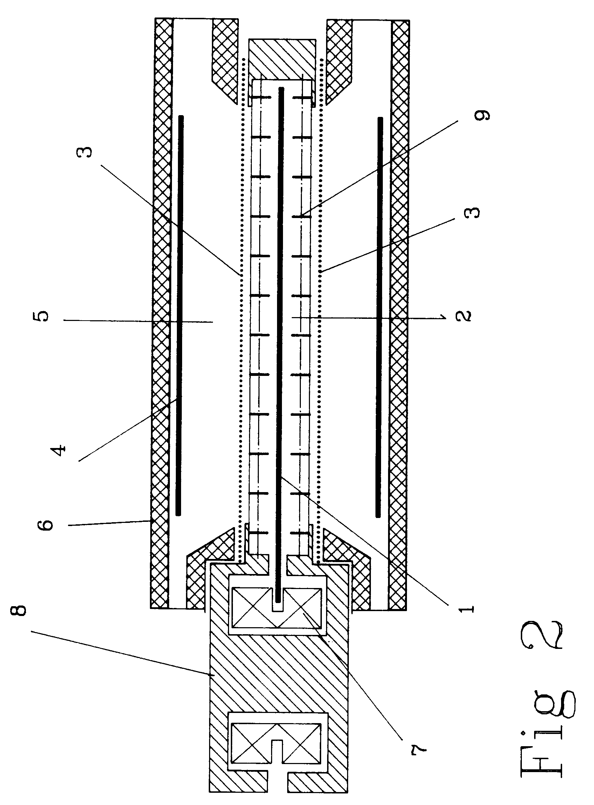

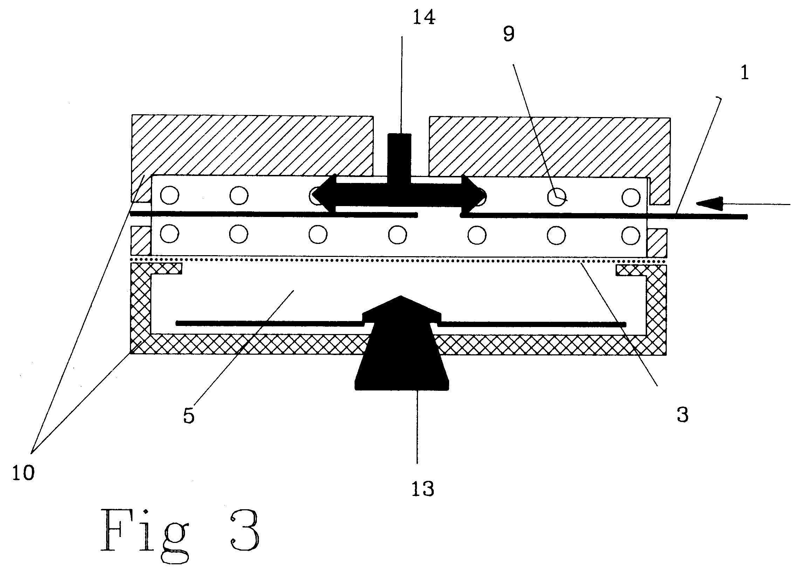

Eine Ausführungsvariante ist in der Figur 2 dargestellt. Hierbei wird vorzugsweise eine Elektrolysemodulbauweise beschrieben bestehend aus dem Gehäuse 6, der Transporteinrichtungen 7 und dem weiteren Gehäuse 8 in dem die Plattenführungsrollen 9 für die Leiterplatte 1, die Membranen 3 oberhalb und unterhalb der Leiterplatte 1, angeordnet sind, die somit eine Trennung zwischen Katolyt 2 und Anolyt 5 bewirken.
Eine weitere Variante wird gemäß Figur 3 beschrieben.
In der Galvanisierzelle 10 ist unterhalb der Leiterplatte 1 mit ihren Führungsrollen 9 eine Membran 3 angeordnet mit der der Raum für den Anolyten 5 gebildet wird. Der Anolytstrom 13, erfolgt in der Mitte quer zur Transportrichtung und der Katolytstrom 14 verteilt sich dann nach rechts und links gleichmäßig.

**Beispiel 2:**

Es wurden 2 HULL-Zellen in Reihe geschaltet. Die erste wurde entsprechend der DIN 50957 mit einer geringen Modifikation verwendet. In der Kathode wurden 4 Reihen Löcher eingebracht mit unterschiedlichen Durchmessern in jeder Reihe, so daß die Löcher mit 4 verschiedenen Durchmessern (0,1 bis 0,8 mm) einen gleichen Abstand zur Anode besitzen. In der 2. Zelle wurde darüber hinaus erfindungsgemäß vor der Kathode im Abstand von 4 mm die Ionenaustauschermembran SELEMION AMV der Firma ASAHI GLASS so angebracht, daß der Elektrolytraum vollständig geteilt wurde.

Die in beiden Zellen mit identischer Elektrolytzusammensetzung abgeschiedene Kupferschichtendicke variierte in der 1. Zelle zwischen 19,4 und 2,1 $\mu$m und in der 2. Zelle zwischen 20,3 und 4,2 $\mu$m. Ebenso lag die in der Innenwand der Löcher abgeschiedene Kupferschichtdicke der auf der planen Fläche daneben abgeschiedenen Schichtdicke in der 2. Zelle deutlich näher.

**Patentansprüche**

1. Membranelektrolysemodul, dadurch gekennzeichnet, daß eine Elektrolysezelle aus einem Katholyten- und einem Anolytenraum, die als durchflutbare Kammern ausgebildet sind, indem durch planparallel zum zu behandelnden Warengut nichtporöse Ionenaustauschermembranen angeordnet werden und die lediglich durch Anionenaustauschermembranen getrennt sind, besteht.

2. Membranelektrolysemodul bestehend aus einem Gefäß mit Anode und Kathode, gefüllt mit einem Elektrolyten, dadurch gekennzeichnet, daß sich zwischen Anode und Kathode eine oder mehrere Ionenaustauschermembranen befinden, die das Elektrolytvolumen in zwei oder mehrere Teile trennen.

3. Membranelektrolysemodul gemäß Anspruch 2, dadurch gekennzeichnet, daß die kathodennahe Ionenaustauschermembran der Form und Größe der Kathodenfläche angepaßt ist.

4. Membranelektrolysemodul gemäß Anspruch 2, dadurch gekennzeichnet, daß in den Teilen des Elektrolytvolumens sich unterschiedliche Elektrolyte und/oder unterschiedliche Zusatzstoffe, beziehungsweise deren Konzentrationen sich befinden.

5. Membranelektrolysemodul gemäß Anspruch 2, dadurch gekennzeichnet, daß der Elektrolytvolumenteil vor der Kathode mit einer Austauschvorrichtung für den Elektrolyten angeordnet ist.

6. Verfahren zur elektrolytischen Schichtabscheidung, bestehend aus dem Einbringen des Galvanisiergutes in eine Elektrolysezelle mit einem Elektrolyt und dem Durchführen der Elektrolyse, dadurch gekennzeichnet, daß vor dem Durchführen der Elektrolyse zwischen Anode und Kathode eine oder mehrere Ionenaustauschermembranen angeordnet werden und der zwischen Anode und Kathode fließende elektrische Strom durch die Ionenaustauschermembran/en geführt wird.

7.  Verfahren zur elektrolytischen Schichtabscheidung nach Anspruch 6, dadurch gekennzeichnet, daß die Ionenaustauschermembran vor der Anordnung in der Elektrolysezelle nach ihrer Art und Qualität in HULL-Zellen, entsprechend der benuzten Galvanisierungstechnologie, geprüft und ausgewählt werden.

8.  Verfahren zur elektrolytischen Schichtabscheidung nach Anspruch 6, dadurch gekennzeichnet, daß die Ionenaustauschermembran, die der Kathode am nächsten liegt, direkt vor dem Kathodenareal angeordnet wird, und gegebenenfalls so gestaltet wird, daß sie grob die Kathodenfläche des Galvanisiergutes wiederholt.

9.  Verwendung des Membranelektrolysemoduls gemäß Ansprüche 1 - 5 zur Erzeugung galvanischer Überzüge oder zur Auflösung metallischer Oberflächen.

10. Verwendung gemäß Anspruch 9 in horizontalen oder vertikalen Durchlaufanlagen.

Fig 1

EP 0 483 937 A1

Fig 2

Fig 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | PATENT ABSTRACTS OF JAPAN<br>vol. 8, no. 11 (C-205)(1448) 18. Januar 1984<br>& JP-A-58 177 487 ( SUMITOMO KINZOKU KOGYO KK )<br>18. Oktober 1983<br>* Zusammenfassung *<br>--- | 1-10 | C25D5/00<br>C25D17/00 |
| X | PATENT ABSTRACTS OF JAPAN<br>vol. 12, no. 405 (C-539)(3252) 26. Oktober 1988<br>& JP-A-63 145 800 ( NISSHIN STEEL CO LTD ) 17. Juni 1988<br>* Zusammenfassung *<br>--- | 1-10 | |
| A | PATENT ABSTRACTS OF JAPAN<br>vol. 8, no. 41 (C-211)(1478) 22. Februar 1984<br>& JP-A-58 199 890 ( TOKUYAMA SODA KK ) 21. November 1983<br>* Zusammenfassung *<br>----- | | |
| | | | **RECHERCHIERTE SACHGEBIETE (Int. Cl.5 )**<br><br>C25D<br>C25F |

Der vorliegende Recherchenbericht wurde für alle Patentansprüche erstellt

| Recherchenort | Abschlußdatum der Recherche | Prüfer |
|---|---|---|
| DEN HAAG | 06 MAERZ 1992 | NGUYEN THE NGHIEP N. |